# EUROPEAN PATENT APPLICATION

(11) **EP 1 882 751 A1**
(43) Date of publication of application: **30.01.2008**
(21) Application number: 07011610.8
(22) Date of filing: 13.06.2007
(51) Int. Cl.: C22C 9/02

(54) **Copper alloy having high strength and high softening resistance**

(30) Priority: 28.07.2006 JP 2006206672
(71) Applicant: KABUSHIKI KAISHA KOBE SEIKO SHO, Kobe-shi, Hyogo 651-8585 (JP)
(72) Inventor: Aruga, Yasuhiro, Nishi-ku, Kobe-shi, Hyogo 651-2271 (JP); Ozaki, Ryoichi, Shimonoseki-shi, Yamaguchi 752-0953 (JP); Kajihara, Katsura, Nishi-ku, Kobe-shi, Hyogo 651-2271 (JP)
(74) Representative: Müller-Boré & Partner Patentanwälte

(57) **Abstract**

Disclosed is a Cu-Fe-P alloy capable of enabling high strength, high electrical conductivity, and excellent softening resistance to coexist. The Cu-Fe-P alloy is suitable for use as a constituent material of a lead frame for a semiconductor device. With the Cu-Fe-P alloy with strength rendered higher by micronizing Fe-containing compounds, when enhancing softening resistance by increasing Sn content so as to exceed 0.5 mass%, at least one element selected from the group consisting of Ni, Mg, Ca, Al, Si, and Cr, in trace amounts, are caused to be additionally contained to thereby check cracking likely to occur at the time of forging and hot rolling in a process of producing the copper alloy, as a result of an increase in the Sn content.

## Description

The invention relates to a copper alloy having high strength and high softening resistance, such as a copper alloy suitable for use as a constituent material of a lead frame for a semiconductor device. The copper alloy according to the invention is for use not only as the constituent material of the lead frame, but also as constituent materials of electrical and electronic parts such as semiconductor parts, other than the lead frame for the semiconductor device, a printed wiring board, and so forth, constituent materials of other electrical and electronic parts such as mechanical parts including a switch, bus bar, terminal, connector, and the like. In the following description, however, the case of the copper alloy being used for a lead frame as a semiconductor part, in particular, will be primarily described as a representative application example.

As a copper alloy for use in an IC lead frame, a Cu-Fe-P alloy has been commonly employed in the past. Examples of the Cu-Fe-P alloy include a copper alloy containing 0.05 to 0.15% Fe, and 0.025 to 0.04% P (C19210 alloy), and a copper alloy containing 2.1 to 2.6% Fe, 0.015 to 0.15% P, and 0.05 to 0.20% Zn (CDA194 alloy). If Fe or an inter-metallic compound such as Fe-P or the like is precipitated in a copper matrix phase, those Cu-Fe-P alloys are found superior among copper alloys in terms of strength, electrical conductivity, and thermal conductivity, so that those Cu-Fe-P alloys are commonly used as the international standard alloys.

As the trend of a semiconductor device used in an electronic equipment toward a larger capacity, smaller size, and higher integration has lately become pronounced, so progress toward a smaller cross-sectional area of the lead frame used in the semiconductor device has advanced, and consequently, still higher strength, electrical conductivity, and thermal conductivity are required of the lead frame. As a result, still higher strength, electrical conductivity, and thermal conductivity are required of a copper alloy sheet for use in the lead frame of the semiconductor device.

To cope with such requirements, there have since been proposed various methods for controlling the internal structure and precipitation condition of the Cu-Fe-P alloys. For example, a proposal has been made for a well-balanced copper alloy having strength and electrical conductivity, commensurate to an amount of Fe added, produced by controlling a precipitation behavior of Fe, prone to sensitively change depending on an annealing condition in the production process thereof to thereby suppress fluctuation in properties thereof (refer to Patent Document 1).

On the other hand, Cu-Fe-P alloy sheets having higher strength, and higher electrical conductivity are required to have excellent softening resistance hardly causing deterioration in strength even after application of heat treatment such as stress relief annealing or the like.

When a Cu-Fe-P alloy sheet is worked into a lead frame and so forth, the Cu-Fe-P alloy sheet is commonly reduced into a multi-pin shape by stamping (punching). To cope with the need for miniaturization, smaller wall-thickness, and lighter weight of the electrical and electronic parts, described as above, progress toward smaller wall-thickness, and more pins of the Cu-Fe-P alloy sheet as material thereof has since advanced, so that stress for distortion is prone to remain in a workpiece after the stamping. Consequently, there has been a tendency that the pins are rendered irregular. Accordingly, a heat treatment (stress relief annealing) is normally applied to the Cu-Fe-P alloy sheet in the multi-pin shape, obtained by the stamping, thereby removing the distortion.

However, material subjected to such a heat treatment as described is prone to be softened, and is unable to maintain a mechanical strength before the heat treatment. Further, in respect of a production process, application of the heat treatment at a higher temperature for shorter time is required from the viewpoint of enhancement in productivity, so that there is strong demand for softening resistance enabling a high strength to be maintained even after the heat treatment applied at the higher temperature.

In order to cope with a problem of how to enhance softening resistance, there have since been devised countermeasures whereby, for example, trace amounts of additive elements such as Sn, Mg, Ca, and so forth, in addition to trace amounts of alloying elements such as Fe, P, Zn, and so forth, are contained in copper alloys, or respective addition amounts thereof are adjusted. Further, control of crystals and precipitates in copper alloys has since been carried out. However, with the adjustment of chemical components, and the control of crystals and precipitates, alone, it is impossible to adequately address problems of copper alloy parts in respect of reduction in weight as well as size, resistance to distortion at high temperature, and so forth, so that techniques for controlling the structure, and so forth of the Cu-Fe-P alloys have been further proposed.

For example, in Patent Document 2, it has been proposed to obtain a high softening resistance by controlling structures themselves of crystals and precipitates, in a Cu-Fe-P alloy with effective Fe content as high as not lower than 0.7%. Further, in Patent Documents 3, and 4, it has been proposed to obtain a high softening resistance by controlling aggregate structures.
[Patent Document 1] JP - B No. 3725506
[Patent Document 2] JP - A No. 91895 / 2004
[Patent Document 3] JP - A No. 139501 / 2005
[Patent Document 4] JP - A No. 339028 / 2002

However, with the Cu-Fe-P alloy described in those Patent Documents referred to as above, effective Fe content thereof is in excess of 0.5% even in the lowest case, and is therefore relatively high. In this regard, those techniques disclosed in Patent Documents 2, 3, 4, respectively, certainly appear effective for enhancement of softening resistance in the case of the Cu-Fe-P alloy with a high Fe content, but are not necessarily effective if Fe content is relatively low.

Further, there occurs another problem of deterioration in electrical conductivity, and Ag plating property when Fe content becomes high. In order to improve electrical conductivity in an attempt to cope with this problem, there are available, for example, means for increasing a precipitation amount. However, an attempt to increase the precipitation amount will concurrently result in coarsening of the precipitate, which will lead to a problem of deterioration in strength and softening resistance.

In other words, according to the techniques disclosed in Patent Documents 2, 3, 4, respectively, higher strength and higher electrical conductivity, required of the Cu-Fe-P alloy, cannot be provided in combination with softening resistance. It follows that even if the respective techniques disclosed in Patent Documents 2, 3, 4, as they are, are applied to the Cu-Fe-P alloy that is rendered higher in electrical conductivity as well as strength by virtue of chemical composition with lower Fe content, it is not possible to obtain such a high-level softening resistance as required of the above-described lead frame, and so forth.

Meanwhile, it is well known that the softening resistance of a copper alloy can be enhanced if the additive elements such as Sn, and so forth, in relatively large amounts, are contained in the copper alloy. However, if the Cu-Fe-P alloy contains the additive elements such as Sn, and so forth, in large amounts, the Cu-Fe-P alloy will be prone to undergo cracking at the time of forging and hot rolling, due to excessive segregation (presence) of a large amount Sn, on grain boundaries. Hence, it is difficult to efficiently produce the Cu-Fe-P alloy containing Sn.

The invention has been developed to resolve such problems as described in the foregoing, and it is therefore an object of the invention to provide a Cu-Fe-P alloy having both high strength and high softening resistance.

To that end, the invention provides a copper alloy having both high strength and high softening resistance, essentially containing Fe in a range of 0.01 to 4.0 mass%, P in a range of 0.01 to 0.15 mass%, Sn in excess of 0.5 mass%, not higher than 5.0 mass%, and at least one element selected from the group consisting of Ni, Mg, Ca, Al, Si, and Cr, in a range of 0.001 to 0.02 mass%, in total, the remainder being Cu and unavoidable impurities, wherein a ratio of an amount of Fe in extracted residue that is extracted and separated over a filter 0.1 µm in opening size by an extracted residue method to an amount of Fe contained in the copper alloy is not more than 80 %.

In this connection, the extracted residue method described as above, comprises the steps of:
immersing 10 g of the copper alloy in 300 ml of methanol solution containing 10 mass% concentration of ammonium acetate, and using the copper alloy as an anode;
applying a galvanostatic electrolytic method using platinum as a cathode at a current density of 10 mA / cm², thereby dissolving the copper alloy into the methanol solution;
subjecting the methanol solution with the copper alloy dissolved therein to filtration under reduced pressure by use of a polycarbonate membrane filter with an opening size of 0.1 µm; and
separating and extracting undissolved residue on the filer.

Further, the amount of Fe in the extracted residue is found by dissolving the undissolved residue on the filter into a solution prepared by mixing agua regia with water at a ratio of 1 to 1 to be subsequently analyzed by the ICP emission spectroscopy.

With the invention, Fe content is preferably in a range of 0.01 to 0.5 % in the case of the chemical composition of the copper alloy having both high strength and high softening resistance, in particular, including the Fe content in a relative low region.

Further, with the invention, a Cu-Fe - (P, Zn) alloy, in particular, preferably further contains Zn in a range of 0.005 to 3.0 %.

Still further, with the invention, those copper alloys each are preferably in the form of a copper alloy sheet for use as an IC lead frame.

The copper alloy according to the invention has a feature in that a relatively large amount of Sn is contained therein in order to enhance softening resistance. In contrast, Patent Document 1 has disclosed that if a Cu-Fe-P alloy contains an excessively large amount of Sn, this will cause formation of coarse compounds at the time of forging, due to macro-segregation of Sn while causing deterioration in electrical conductivity.

An adverse effect due to the formation of the coarse compounds at the time of forging, due to the macro-segregation of Sn when the Cu-Fe-P alloy contains the excessively large amount of Sn, as stated in Patent Document 1, is not necessarily accurate description. That is, the adverse effect, in the strict sense, when the Cu-Fe-P alloy contains the excessively large amount of Sn, is cracking at the time of forging and hot rolling, due to the excessive segregation (presence) of Sn contained in a large amount, on the grain boundaries.

Sn is large in atomic radius as compared with Cu and is also faster in diffusion, so that Sn has difficulty in being present within Cu matrix and Cu grains, but is prone to be present on the grain boundaries. Accordingly, it is presumed that if a Cu-Fe-P alloy contains a large amount of Sn, this will reinforce the excessive segregation of Sn, on the grain boundaries, thereby rendering the Cu-Fe-P alloy susceptible to cracking at the time of forging and hot rolling.

In contrast, the invention has another feature in that the Cu-Fe-P alloy containing a relatively large amount of Sn is caused to further contain Ni, Mg, Ca, Al, Si, and Cr, in trace amounts. Those elements Ni, Mg, Ca, Al, Si, and Cr, contained in trace amounts, will be present on the grain boundaries, in more preference to Sn or in preference to Sn to an equivalent degree thereto. Consequently, the excessive segregation (presence) of the large amount of Sn, on the grain boundaries, can be suppressed. Meanwhile, as those elements, in small amounts, are contained in the copper alloy, even if those elements are present on the grain boundaries, this will not foster cracking at the time of forging and hot rolling.

Those elements Ni, Mg, Ca, A1, Si, and Cr, rather have a considerably large effect of suppressing the excessive segregation (presence) of Sn, on the grain boundaries, thereby checking cracking at the time of forging and hot rolling.

Accordingly, the copper alloy according to the invention is capable of containing a relatively large amount of Sn, in addition to checking cracking at the time of forging, and hot rolling, and of enhancing softening resistance. Furthermore, such an advantageous effect of enhanced softening resistance will not be dependent on Fe content unlike the case of the conventional technology for enhancing softening resistance, and can be exhibited even in the case of the Cu-Fe-P alloy with Fe content in a relative low region not higher than 0.5 %

### (Chemical Composition of Copper Alloy Sheet)

Chemical composition of a copper alloy according to an embedment of the invention is described hereinafter. The copper alloy according to one embodiment of the invention is a copper alloy having composition of Fe in a range of 0.01 to 4.0 mass%, P in a range of 0.01 to 0.15 mass%, Sn in excess of 0.5 mass%, not higher than 5.0 mass%, and at least one element selected from the group consisting of Ni, Mg, Ca, Al, Si, and Cr, in a range of 0.001 to 0.02 mass%, in total, the remainder being Cu and unavoidable impurities, in order to meet strength, and electrical conductivity, representing basic properties necessary for use in an IC lead frame, and so forth, together with softening resistance.

To meet strength, and electrical conductivity as the basic properties necessary for use in the IC lead frame, and so forth, the copper alloy needs to have tensile strength not less than 600 MPa, and electrical conductivity not less than 20 % IACS. In addition to the basic composition described, the copper alloy may contain selective additive elements and impurity elements, other than that, within a range where the basic properties as described are not adversely affected. Further, the following element contents are all expressed in terms of mass%. (Fe)

Fe is precipitated as Fe or a Fe-group intermetallic compound, and is a primary element for enhancing the strength and softening resistance of a copper alloy. If Fe content is less than 0.1 %, a formation amount of Fe precipitate grains is less, so that contribution thereof, to enhancement of strength, is insufficient although the need for enhancement of electrical conductivity is met, resulting in insufficient strength.

However, if the Fe content becomes higher, another problem occurs in that electrical conductivity, and Ag plating property undergo deterioration. In this connection, in order to enhance electrical conductivity, and Ag plating property, the upper limit of Fe content is preferably 0.5 % as composition in a low Fe content region of the copper alloy according to the invention, particularly having high strength and high softening resistance.

Further, if the Fe content exceeds 3.0 %, electrical conductivity is prone to deteriorate, and if an attempt is made to increase a precipitation amount in order to forcefully increase electrical conductivity, this will concurrently result in coarsening of the precipitate, so that there occurs deterioration in strength and bending workability. Further, when rolling is applied to an ingot, macro-precipitates of Fe are formed upon heating prior to hot rolling or during intermediate annealing, whereupon rolling workability is caused to deteriorate, and in addition, the macro-precipitates remain in a final product, resulting in deterioration of softening resistance.

Accordingly, the upper limit of Fe content is set to not higher than 3.0 %, preferably not higher than 0.5 % while essential Fe content is in a range of 0.01 to 3.0 %, preferably in a range of 0.01 to 0.5 %.

### (Sn)

Sn is an element contributing to enhancement in the strength and softening resistance of the copper alloy. If Sn content is not higher than 0. 5 %, Sn does not contribute to higher strength and higher softening resistance. Meanwhile, if Sn content is in excess of 5 %, being excessively high, it becomes impossible to suppress excessive segregation (presence) of contained Sn, on grain boundaries, because of an excessive amount of Sn even when Ni, Mg, Ca, Al, Si, and Cr, in trace amounts, are contained. Accordingly, essential Sn content is set to fall in a relatively wide range exceeding 0.5%, not higher than 5.0%. (Ni, Mg, Ca, Al, Si, Cr),

If elements Ni, Mg, Ca, Al, Si, and Cr, in small amounts, are contained, the elements will be present on grain boundaries in more preference to Sn or in preference to Sn to an equivalent degree thereto. Consequently, the excessive segregation (presence) of the large amount of Sn, on the grain boundaries, as previously described, can be suppressed, and cracking can thereby be suppressed at the time of forging and hot rolling. Since a series of those elements, in small amounts, are contained in the copper alloy, even if those elements are present on the grain boundaries, this will not foster cracking at the time of forging and hot rolling. Such an advantageous effect can be exhibited if at least one element selected from the group consisting of Ni, Mg, Ca, Al, Si, and Cr, not lower than 0.001 % in total, are contained. Meanwhile, there is no need at all for the copper alloy containing the series of those elements, in excess of 0.02 %. If the content thereof is higher than that, this will cause the series of those elements to be precipitated on the grain boundaries or the like, thereby fostering the cracking at the time of forging and hot rolling rather than suppressing. Accordingly, with the invention, at least one element selected from the group consisting of Ni, Mg, Ca, Al, Si, and Cr, in a range of 0.001 to 0.02 mass%, in total, is essentially contained in the copper alloy.

### (P)

P is an essential element for increasing the strength of a copper alloy by reacting with Fe to thereby form a compound besides having the function of deoxidizing the copper alloy in molten state. If P content is lower than 0.01 %, the compound is insufficiently precipitated depending on a production condition, so that a desired strength cannot be obtained, and an advantageous effect of the copper alloy containing P will be lost. On the other hand, if P content becomes higher, exceeding 0.3 %, this will cause not only electrical conductivity but also rolling workability to deteriorate. Accordingly, P content is set to a range of 0.01 to 0.3 %.

### (Zn)

Zn is an element for improving resistance to thermal releasability of solder and Sn plating of the copper alloy, necessary for the lead frame or the like. If Zn content when Zn is selectively contained is lower than 0.005%, a desired advantageous effect cannot be obtained. On the other hand, if Zn content is in excess of 3.0 %, not only wettability will deteriorate but also deterioration in electrical conductivity will increase. Accordingly, Zn content when Zn is selectively contained is set to a range of 0.005 to 3.0 %.

### (Other Elements)

With the invention, metal elements other than the above-described are basically impurities. However, not only pure copper ingot but also scrap of electronic part material is lately used as raw material to be melted. In such cases, there are times when other metal materials resulting from combination of plating components with the copper alloy components are unavoidably mixed into the copper alloy (in molten state) according o the invention. Accordingly, with the invention, the content of the other metal elements prone to be mixed, other than the above-described, is specified as tolerance (the upper limit value) below which the advantageous effects of the invention are not adversely affected.

At least one selected from the group consisting of Mn, Zr, Ag, Cd, Be, Ti, Co, S, Au, Pt, Pb, Bi, and Sb, up to 1.0 mass% in total, are tolerated. Those elements even have an advantageous effect of enhancing the strength of the copper alloy. However, if the content thereof is excessively high, this also will cause coarse crystals and oxides to be prone to occur, and deterioration in electrical conductivity also will be considerable.

### (Fe-base Compounds)

With the invention, an Fe-base compound, such as an Fe-base oxide, a Fe-base precipitate, and so forth, produced due to Fe contained in the copper alloy, is controlled in size. More specifically, while a ratio of a coarse Fe-base compound (referred to also as a coarse product), making no contribution to enhancement in the strength of the copper alloy, is lowered as much as possible, a ratio of a fine Fe-base compound (referred to also as a fine product), making effective contribution to enhancement in the strength of the copper alloy, is raised as much as possible.

In this connection, the Fe-base oxide, and the Fe-base precipitate refer to an Fe-containing oxide, and Fe-containing precipitate or mixtures thereof, respectively, regardless of chemical composition thereof. The Fe-containing precipitate includes, for example, an Fe particle, and a compound including Fe and P (Fe₃P, F₂P, and so forth).

With the invention, a size boundary of the Fe-base compound is 0.1 µm. More specifically, the.Fe-base compound not less than 0.1 µm in size, separated by an extracted residue method described below, using a filter 0.1 µm in opening size, is defined as the coarse Fe-base compound. And, an amount of the Fe-base compound not less than 0.1 µm in size, as the coarse Fe-base compound, is defined as an amount of Fe in extracted residue that is extracted and separated over the filter 0.1 µm in opening size. Then, a ratio of the amount of Fe in the extracted residue to an amount of Fe contained in the copper alloy is found, which is defined the ratio of the coarse Fe-base compound (the coarse product).

Thus, with the invention, the ratio (percentage) of the amount of Fe in the extracted residue that is extracted and separated over the filter 0.1 µm in opening size by the extracted residue method described below to the amount of Fe contained in the copper alloy is specified to be not more than 80 %. By so doing, it is possible to control the coarse Fe-base compound to thereby raise the ratio of the fine Fe-base compound making effective contribution to the enhancement in the strength, obtaining effects of strength enhancement in magnitude corresponding to Fe content. As a result, deterioration in electrical conductivity can be checked while Fe content can be decreased.

A level of electrical conductivity is substantially dependent on Cu purity, that is, an amount of the additive elements and the alloying elements, contained in the copper alloy, however, the level of electrical conductivity is largely affected by respective solid solution amounts of the alloying elements, and an amount of work strain due to cold rolling, even in the case of an identical chemical composition. The greater a total amount of the crystals and the precipitates, the less the respective solid solution amounts of the alloying elements in the copper alloy become, resulting in enhancement in electrical conductivity. Nevertheless, as an amount of the extracted residue (the amount of the coarse product not less than 0.1 µm in size) increases, so the amount of the fine product decreases, leading to deterioration in strength. Accordingly, if a ratio of the extracted residue is lowered, and the amount of the fine product is increased to reach a ratio at {1 minus (the ratio of the extracted residue)}, this will enable the copper alloy excellent in balance between strength and electrical conductivity to be obtained.

In a common production process, a finished sheet (product) is obtained by repeatedly applying cold rolling, and annealing after execution of forging, soaking, and hot rolling. Control of mechanical properties such as strength level, and so forth is implemented primarily by controlling precipitation of fine precipitates not more than 0.1 µm through adjustment of a hot rolling condition, and an annealing condition. In this case, a solid solution amount of Fe, and so forth, and a precipitation amount of the fine precipitates can be stabilized by diffusion of the alloying elements, such as Fe, and so forth, into adequately dispersed intermetallic compounds.

However, even if the fine precipitates, in large amounts, are precipitated by adjusting the hot rolling condition, and the annealing condition after the hot rolling, it is difficult to strike a balance between high electrical conductivity and high strength. The reason for this is because most of an amount of Fe as added are captured by the oxides occurring at the time of dissolution forging, crystals and coarse precipitates produced during a period from the soaking of the ingot until completion of the hot rolling, so that a production amount of the fine precipitates that should be produced according to the amount of the Fe as added is found unexpectedly small. Furthermore, in the case where there exists a large amount of coarse crystals, the fine precipitates as precipitated in the steps of the cold rolling and the annealing are trapped by the coarse crystals, so that there occurs further decrease in amount of the fine precipitates independently present in the copper matrix phase. For those reasons, it is not possible to strike a good balance between satisfactory strength and electrical conductivity, proportionately to the amount of the Fe as added.

### (Extracted Residue Method)

Now, with respect to the extracted residue method, there are specified basic conditions for enabling measurements to have reproducibility. More specifically, 10 g of a copper alloy as a measurement target is immersed in 300 ml of methanol solution containing 10 mass% concentration of ammonium acetate, and the copper alloy is used as an anode. Meanwhile, a galvanostatic electrolytic method using platinum as a cathode is applied at a current density of 10 mA / cm², thereby dissolving the copper alloy into the methanol solution. The methanol solution with the copper alloy dissolved therein is subjected to filtration under reduced pressure by use of a polycarbonate membrane filter with an opening size of 0.1 µm, and undissolved residue is separated and extracted on the filter before recovery.

In order to dissolve only copper and solid solution elements (matrix), in the copper alloy as the measurement target, and to extract and separate the crystals, the precipitates, and the oxides, in the copper alloy, without being lost due dissolution, use is made of the property of the copper as the matrix of the copper alloy being dissolved in ammonium when oxygen coexists. That is, the above can be implemented by use of a solution of ammonium acetate, ammonium nitrate, and so forth, however, with the use of a methyl alcohol solution of ammonium acetate, using methyl alcohol as a solvent, as above-described, it is possible to promote dissolution reaction of the copper alloy, by the agency of an ammonium salt.

### (Analysis of an Amount of Fe in the Extracted Residue)

Further, with respect to analysis of the amount of Fe in the extracted residue, there are specified basic conditions for enabling measurements to have reproducibility. More specifically, the undissolved residue (extracted residue) on the filter is dissolved into a solution prepared by mixing agua regia with water at a ratio of 1 to 1 to be subsequently analyzed by the ICP emission spectroscopy, thereby finding the amount of Fe in the extracted residue.

### (Production Conditions)

Production conditions preferable for obtaining the copper alloy according to the invention are described hereinafter. In forming, for example, a sheet, the copper alloy of the chemical composition according to the invention is melted, and cast, whereupon an ingot obtained is hot rolled into a hot rolled sheet, and the hot rolled sheet is annealed to be thereby worked to have a thickness as intended by cold rolling. There are cases where the annealing and the cold rolling are repeated according to a final (product) sheet-thickness. That is, it is unnecessary to largely change a common production process itself, and the copper alloy can be produced by the same process as the common production process.

First, a molten copper alloy adjusted so as to have the chemical composition described as above is cast. Forging is executed by a common method such as a continuous forging method, a semicontinuous forging method, and so forth, and the forging is preferably executed at an average cooling rate (solidifying rate) in excess of 5.0°C / sec for a period from the start of the forging up to a time when 600°C is reached. By so doing, formation of coarse compounds can be checked, thereby micronizing the same.

As to the cooling · solidifying rate in the course of forging by the common forging method, the average cooling rate (solidifying rate) does not normally exceed 5.0°C / sec during the period from the start of the forging up to the time when 600°C is reached. If the average cooling rate (solidifying rate) is as slow as less than 5.0°C / sec, oxides are generated on the grain boundaries to thereby turn coarser, and crystals also turn coarser, which is not preferable. From the viewpoint of checking the generation of the oxides, it is more preferable to execute vacuum melting forging, or melting forging in an atmosphere of a low partial pressure of oxygen.

After the ingot is heated in a heating furnace, the ingot is taken out of the furnace, and is subjected to roughing to be subsequently heated or heat treated for homogenization, followed by hot rolling, whereupon a hot-rolled sheet is water-cooled. The hot rolling may be executed according to the common method with a start temperature on the order of 1000 to 600°C, and a completion temperature on the order of 600 to 850°C.

Thereafter, the hot-rolled sheet is subjected to a primary cold rolling called intermediate rolling before annealing and cleaning, and is further subjected to a finishing (final) cold rolling, and a low temperature annealing (final annealing, finish annealing), thereby being worked into a copper alloy sheet with a product sheet-thickness. For example, in the case of a copper alloy sheet for use as a semiconductor material such as a lead frame, the product sheet-thickness is on the order of 0.1 to 0.4 mm.

Further, prior to the primary cold rolling, a solution heat treatment, and a hardening treatment by water-cooling may be applied to the copper alloy sheet. In such a case, a temperature for the solution heat treatment is selected within a range of 750 to 1000°C.

Now, the invention is described in more concrete terms hereinafter with reference to working examples according to the invention, however, it is to be pointed that the invention be not limited in scope thereto.

### Working Examples

Working examples according to the invention are described hereinafter. Thin sheets of various Cu-Fe-P alloys each having a high Sn content were produced, and evaluation was made on properties thereof, such as mechanical properties, electrical conductivity, softening resistance, and so forth. Measurement results thereof are shown in Table 1.

More specifically, Cu-Fe-P alloys of respective chemical compositions shown in Table 1 were melted in a core-less furnace, respectively, to be subsequently subjected to ingot forging by the semicontinuous forging method, whereupon ingots each 70 mm (thickness) x 200 mm (width) x 500 mm (length) were obtained. After surfaces of the respective ingots were subjected to roughing, and heated, hot rolling at 950°C were applied to the respective ingots to be reduced into a hot rolled sheet 16 mm thick, respectively, and the respective hot rolled sheets were quenched in water from a temperature not lower than 750°C. Subsequently, scales were removed, and thereafter, the primary cold rolling (intermediate rolling) was applied thereto. The respective sheets were subjected to roughing, and subsequently, were subjected to the final cold rolling for carrying out three passes of the cold rolling while applying the intermediate annealing in-between, whereupon copper alloy sheets each 0.15 mm in thickness were obtained.

Further, with respect to respective copper alloys shown in Table 1, chemical composition of the remainder thereof, after removing elements described in Table 1, include Cu and unavoidable impurities, and elements Mn, Zr, Ag, Cd, Be, Ti, Co, S, Au, Pt, Pb, Bi, and Sb, measured as the unavoidable impurities, were found at 0.003 mass% in total.

A test specimen was sampled from respective Cu-Fe-P alloy sheets obtained, and a ratio (percentage: %) of an amount of Fe contained in extracted residue to an amount of Fe contained in the respective copper alloys was found by the extracted residue method, and the method of measuring the amount of Fe in the extracted residue, as previously described.

A test specimen was sampled from the respective Cu-Fe-P alloy sheets obtained, and was subjected to a tensile test, hardness measurement, and electrical conductivity measurement. The tensile test using JIS No. 13 test-specimen was conducted under conditions of room temperature, test velocity at 10.0 mm / min, and GL = 50 mm with the use of a 5882-type universal testing machine manufactured by Instron Co.

### (Hardness Measurement)

Hardness measurement on the test specimens of the respective Cu-Fe-P alloy sheets was conducted by applying a load of 0.5 kg at three spots with the use of a micro-Vickers hardness tester (trade name: micro hardness tester) manufactured by Matsuzawa Precision Machinery Co., Ltd, and a mean value of hardness values obtained was defined as hardness.

### (Electrical Conductivity Measurement)

The test specimens of the respective Cu-Fe-P alloy sheets were reduced into a short-strip-like shape 10 mm (width) x 300 mm (length), respectively, by milling, and electrical resistance of the test specimen was measured by use a double-bridge type resistance measurement meter, whereupon electrical conductivity was worked out by the average sectional area method.

### (Softening resistance)

Softening resistance of respective test specimens was evaluated on the basis of a degree of deterioration in hardness, due to annealing. The respective test specimens {10 mm (width) x 10 mm (length) } were optionally sampled from respective sheets obtained by annealing respective product copper alloy sheets after the final cold rolling and after the final low-temperature annealing, at 500°C for one minute, before water cooled. Hardness measurement on the respective test specimens was conducted by applying a load of 0.5 kg with the use of a micro-Vickers hardness tester (trade name: micro hardness tester) manufactured by Matsuzawa Precision Machinery Co., Ltd.

As is evident from Table 1, working examples 1 to 8, wherein chemical composition is within the chemical compositions according to the invention with relatively high Sn contents, and the ratio of the amount of Fe contained in the extracted residue to the amount of Fe contained in the copper alloy is 80 % or less, were found to have high strength, and high electrical conductivity, and were also found excellent in softening resistance. These results show that the invention can provide a Cu-Fe-P alloy capable of enabling high strength, high electrical conductivity, and excellent softening resistance to coexist even if the chemical composition thereof includes Fe content in a relative low region.

In contrast, comparative examples 9 to 11 each had prerequisite composition of Fe, Sn, P, Zn, falling within respective ranges according to the invention, however, did not contain at least one element selected from the group consisting of Ni, Mg, Ca, Al, Si, and Cr. Consequently, many cracks occurred thereto at the time of forging and hot rolling during the production process for those copper alloys. The same applies to copper alloys according to comparative examples 14 to 16, wherein not less than the one element or the two elements, selected from the group consisting of Ni, Mg, Ca, Al, Si, and Cr, were excessively low in content so as to be below the lower limit.

Further, in the case of comparative example 12 wherein Fe content was 0.003 %, below the lower limit 0.01 %, strength was found excessively low. Still further, in the case of comparative example 13 wherein Sn content was 0.44 %, below the lower limit 0.5 %, softening resistance was found poor.

Based on the results described as above, it is possible to support critical significance of the composition and the structure of the copper alloy according to the invention, and significance of preferable production conditions for obtaining the composition and the structure in order to be capable of containing a relatively large amount of Sn in addition to checking cracking at the time of forging, and hot rolling, and to have excellent softening resistance in addition to a high strength regardless of Fe content.

**Table 1**

| classification | alloy number | chemical composition of copper alloy sheet (the remainder: Cu, impurities) | | | | | copper alloy structure | copper alloy sheet properties | | | |
|---|---|---|---|---|---|---|---|---|---|---|---|
| | | Fe(*A) | P | Zn | Sn | Ni, Mg, Ca, Al, Si, Cr | a ratio of an amount (*B) of Fe in extracted residue to an amount (A) of Fe contained in the copper alloy | tensile strength | hardness | electrical conductivity | a degree of deterioration in hardness, due to annealing |
| | | | | | | | B/Ax 100% | MPa | Hv | %lACS | Hv |
| working example | 1 | 0.32 | 0.11 | - | 0.62 | Ni : 0.003 | 37 | 690 | 205 | 54 | 13 |
| | 2 | 0.32 | 0.11 | 0.31 | 1.1 | Ni : 0.007 | 32 | 720 | 215 | 45 | 10 |
| | 3 | 0.32 | 0.11 | 0.31 | 2.2 | Mg : 0.006 | 48 | 770 | 230 | 33 | 28 |
| | 4 | 0.030 | 0.050 | - | 0.60 | Ca : 0.005 | 35 | 640 | 195 | 63 | 19 |
| | 5 | 3.3 | 0.11 | - | 0.62 | Ca: 0.003, Al: 0.005 | 41 | 705 | 210 | 49 | 12 |
| | 6 | 0.17 | 0.060 | 0.052 | 0.59 | Si : 0.003, Cr : 0.004 | 43 | 665 | 200 | 58 | 23 |
| | 7 | 0.32 | 0.11 | 2.4 | 0.62 | Ni : 0.005, Mg : 0.003, AI : 0.004 | 36 | 725 | 215 | 48 | 12 |
| | 8 | 0.32 | 0.11 | 0.31 | 4.0 | Ca : 0.003, Si : 0.005, Cr : 0.004 | 42 | 810 | 245 | 27 | 18 |
| comparative example | 9 | 0.32 | 0.11 | 0.31. | 0.62 | - | cracking | - | - | - | - |
| | 10 | 0.32 | 0.11 | 0.31 | 1.1 | - | cracking | - | - | - | - |
| | 11 | 0.32 | 0.11 | 0.31 | 4.0 | - | cracking | - | - | - | - |
| | 12 | 0.003 | 0.050 | - | 0.60 | Ni : 0.003 | 33 | 540 | 165 | 67 | 20 |
| | 13 | 0.32 | 0.11 | - | 0.44 | Ni : 0.005 | 40 | 650 | 195 | 59 | 35 |
| | 14 | 0.32 | 0.11 | - | 0.60 | Mg : 0.0004 | cracking | - | - | - | - |
| | 15 | 0.32 | 0.11 | - | 0.92 | Ca : 0.0004 | cracking | - | - | - | - |
| | 16 | 0.32 | 0.11 | - | 0.60 | Al : 0.0003 | cracking | - | - | - | - |

| | | | | | | | | | | | |
|---|---|---|---|---|---|---|---|---|---|---|---|
| * In expression of respective element contents, ( - ) indicates the content below the detection limit. * The annealing condition adopted for measuring the degree of deterioration in hardness was 500°C for one minute. | | | | | | | | | | | |

As described hereinbefore, the invention can provide a Cu-Fe-P alloy wherein high strength, and excellent softening resistance can coexist. As a result, the invention is applicable to various usage requiring high strength, high electrical conductivity, and high softening resistance, including electrical and electronic parts reduced in size and weight, such as an IC lead frame, and parts other than the lead frame, including a connector, terminal, switch, relay, and the like.

## Claims

1. A copper alloy having a high strength, and high softening resistance comprising Fe in a range of 0.01 to 4.0 mass%, P in a range of 0.01 to 0.15 mass%, Sn in excess of 0.5 mass%, not higher than 5.0 mass%, and at least one element selected from the group consisting of Ni, Mg, Ca, Al, Si, and Cr, in a range of 0.001 to 0.02 mass%, in total, the remainder being Cu and unavoidable impurities, wherein a ratio of an amount of Fe in extracted residue that is extracted and separated over a filter 0. 1 µm in opening size by an extracted residue method to an amount of Fe contained in the copper alloy is not more than 80 %,
said extracted residue method comprising the steps of:
immersing 10 g of the copper alloy in 300 ml of methanol solution containing 10 mass% concentration of ammonium acetate, and using the copper alloy as an anode;
applying a galvanostatic electrolytic method using platinum as a cathode at a current density of 10 mA / cm², thereby dissolving the copper alloy into the methanol solution;
subjecting the methanol solution with the copper alloy dissolved therein to filtration under reduced pressure by use of a polycarbonate membrane filter with an opening size of 0.1 µm; and
separating and extracting undissolved residue on the filer,
the amount of Fe in the extracted residue being found by dissolving the undissolved residue on the filter into a solution prepared by mixing agua regia with water at a ratio of 1 to 1 to be subsequently analyzed by the ICP emission spectroscopy.

2. The copper alloy according to claim 1, wherein Fe content is in a range of 0.01 to 0.5 mass%.

3. The copper alloy according to claims 1 or 2, further comprising Zn in a range of 0.005 to 3.0 mass%.

4. The copper alloy according to any of claims 1 to 3, wherein the copper alloy is in the form of a copper alloy sheet for use as an IC lead frame.
